# EUROPÄISCHE PATENTSCHRIFT

(11) **EP 1 552 611 B1**
(45) Veröffentlichungstag und Bekanntmachung des Hinweises auf die Patenterteilung: **25.01.2006**
(21) Anmeldenummer: 03785606.9
(22) Anmeldetag: 01.10.2003
(51) Int. Cl.: H03K 7/08

(54) **VERFAHREN UND VORRICHTUNG ZUR ERZEUGNUNG VON ZWEI- ODER MEHRKANALIGEN PULSWEITENMODULIERTEN RECHTECKPULSEN**
METHOD AND DEVICE FOR THE PRODUCTION OF TWO-CHANNEL OR MULTI-CHANNEL PULSE-WIDTH-MODULATED RECTANGULAR PULSES
PROCEDE ET DISPOSITIF DE GENERATION D'IMPULSIONS RECTANGULAIRES MODULEES EN LARGEUR A AU MOINS DEUX CANAUX

(30) Priorität: 16.10.2002 DE 10248304
(43) Veröffentlichungstag der Anmeldung: 13.07.2005
(73) Patentinhaber: SIEMENS AKTIENGESELLSCHAFT, 80333 München (DE)
(72) Erfinder: BERGER, Erik, A-1030 Wien (AT); EISNER, Martin, A-2484 Weigelsdorf (AT); MESCHIK, Martin, A-1110 Wien (AT); RAHMANIAN SHAHRI, Navid, A-1080 Wien (AT)
(86) Internationale Anmeldenummer: PCT/EP2003/010867
(87) Internationale Veröffentlichungsnummer: WO 2004/036749

(56) Entgegenhaltungen:
- US-A- 5 227 961
- US-A- 5 506 484

## Beschreibung

Die Erfindung betrifft ein Verfahren zur Erzeugung von zwei- oder mehrkanaligen pulsweitenmodulierten Rechteckpulsen.

Weiters betrifft die Erfindung eine Vorrichtung zur Erzeugung von zwei- oder mehrkanaligen pulsweitenmodulierten Rechteckpulsen.

Bei der Ansteuerung bestimmter Schaltungsformen, z.B. von Übertragern, mehrphasigen Motoren, etc., ist es bei Verwendung von zwei oder mehr pulsweitenmodulierten Ansteuersignalen oftmals notwendig, dass diese einen bestimmten Verlauf aufweisen, um beispielsweise zu vermeiden, dass ein solcher Übertrager in die Sättigung gelangt und dadurch beschädigt oder zerstört Wird.

Die Erzeugung von mehrkanaligen pulsweitenmodulierten Pulsen nach dem ersten Teil von Anspruch 1 ist aus US 5 506 484 A und US 5 227 961 A bekannt.

Bisher wurden solche Ansteuersignale dadurch erzeugt, dass zwei oder mehr pulsweitenmodulierte Signale, die in aufeinanderfolgenden Zeitabschnitten dieselbe Einschaltzeit aufweisen müssen, verwendet werden. Außerdem muss zusätzlich noch in jeder zweiten Phase der jeweils andere Ansteuerausgang ausgetastet werden.

Diese Vorgangsweise ist allerdings kompliziert und aufwändig, und bei Verwendung eines Microcontrollers zur Ansteuerung werden teilweise bis zu 80% der Ressourcen des Microcontrollers nur für die Erzeugung von symmetrischen, pulsweitenmodulierten Ansteuersignale aufgewendet, sodass nur noch wenige Ressourcen des Microcontrollers für andere Aufgaben zur Verfügung stehen.

Bei der Ansteuerung von beispielsweise Mehrphasenmotoren, wie 5-Phasen-Motoren, die mit eingangs erwähnten Signalen möglich ist, treten bei den herkömmlichen Verfahren zur Änderung der Geschwindigkeit des Motors hohe Umschaltverluste auf.

Es ist eine Aufgabe der Erfindung, auf einfache und ressourcenschonende Art und Weise zwei oder mehr pulsweitenmodulierte Signale zu erzeugen.

Weiters ist es eine Aufgabe der Erfindung, zwei- öder mehrkanalige pulsweitenmodulierte Signale zu erzeugen, welche eine Vermeidung von hohen Umschaltverlusten erlauben.

Diese Aufgaben werden mit einem eingangs erwähnten Verfahren bzw. mit einer eingangs erwähnten Vorrichtung dadurch gelöst, dass erfindungsgemäß innerhalb einer Periode an jedem Kanal genau ein Puls abgegeben wird, und das Einsetzen eines Pulses bezogen auf einen Einsetzzeitpunkt um eine aktuelle Totzeit zeitverzögert wird, die Totzeit jeweils für zumindest eine Periode konstant gehalten wird, und für eine Modulation der Pulsweite ein neuer Wert für die Totzeit und/oder ein neuer wert für die Periodendauer erzeugt wird und die aktuelle Tot= zeit und/oder die aktuelle Periodendauer zu Beginn der gewünschten Periode auf den neuen Wert der Totzeit und/oder der Periodendauer gesetzt wird.

Durch diesen "Block Mode"; bei dem jeder Kanal für eine bestimmte Zeit Ein- und dann wieder ausgeschaltet wird, wird beispielsweise das häufige Ein- und Ausschalten bei dem Betreiben eines Mehrphasenmotors, das zu hohen Umschaltverlusten bei einer Geschwindigkeitsänderung des Motors führt, vermieden.

Durch Änderung der Totzeit Und/oder der Periodendauer wird außerdem - was alternativ oder zusätzlich genutzt werden kann - erreicht, dass sich die Signale, d.h. die Rechteckimpulse der Signale einer Periode aller Kanäle in gleichem Ausmaß verbreitern oder verschmälern, sich also unter gewissen Umständen eine "symmetrische" Pulsweitenmodulation ergibt. Die Erfindung lässt sich einfach realisieren, da lediglich ein bzw. zwei Parameter - die Tötzeit und/oder die Periodendauer - entsprechend geändert werden müssen.

Besonders einfach lassen nicht-überlappende, symmetrische Signale erzeugen, wenn zwei aufeinanderfolgende Pulse an verschiedenen Kanälen jeweils zeitlich durch eine aktuelle Tot= zeit voneinander getrennt sind.

Damit eine Änderung eines der Parameter zuverlässig nicht be= reits in einer laufenden Periode sondern frühestens in der nächsten Periode zur Wirkung kommt, wird der neue Wert der Totzeit und/oder der Periodendauer unabhängig von dem aktuellen Wert der Totzeit und/oder der Periodendauer zwischengespeichert und der aktuelle Wert mit dem neuen Wert zu Beginn der gewünschten Periode überschrieben.

Besonders einfach lässt sich die Erfindung dabei realisieren, wenn die Totzeit und/oder die Periodendauer zu Beginn jeder Periode auf den neuen Wert gesetzt wird. Durch diese Voreinstellung wird zu Beginn jeder Periode der aktuelle Wert mit dem zwischengespeicherten Wert überschrieben, auch wenn diese sich in der Zwischenzeit nicht geändert haben. Damit ist eine aufwändige Programmierung, die ein solches Update nur dann durchführt, wenn tatsächlich eine Änderung eines der Parameter Totzeit bzw. Periodendauer stattgefunden hat, nicht notwendig, sodass eine einfache Realisierung möglich ist.

Besonders einfach erhält man symmetrische Signale, wenn die maximale Pulsweite für einen Kanal auf die Dauer der Periode geteilt durch die Anzahl der Kanäle gesetzt wird.

Insbesondere ist dabei vorgesehen, dass bei zwei Kanälen die maximale Pulsweite auf die halbe Dauer einer Periode gesetzt wird.

Weiters ist vorgesehen, dass bei n Kanälen jeweils nach Ablauf der Dauer der maximalen Pulsweite für den ersten bis den (n-1) -ten Kanal ein Interrupt-Signal erzeugt und der Beginn der Totzeit für den nächsten Kanal angezeigt wird sowie am Ende einer Periode ein Interrupt-Signal generiert wird, mit dem der Beginn der Totzeit für den ersten Kanal bzw. der Beginn einer neuen Periode markiert wird.

Zweckmäßig ist es dabei, wenn mit dem Interrupt-Signal das Überschreiben der aktuellen Totzeit und/oder der aktuellem periodendauer mit dem neuen Wert für die Totzeit und/oder für die Periodendauer initiiert wird, da auf diese Weise sichergestellt werden kann, dass diese Anderungen auf die aktuelle Periode keinen Einfluss haben.

Generell gilt, dass sowohl Pulsweite, Periodendauer als auch Totzeit per Interrupt ein Update erfahren können. Deshalb sind auch die entsprechenden Register doppelgepuffert.

Damit eine Doppelpufferung der Totzeit möglich ist, sodass eine "Änderung" der Totzeit, d.h. eine Generierung eines zweiten Wertes für die Totzeit, ohne Einfluss auf die aktuelle Periode möglich ist, weist die erfindüngsgemäße Steuerung zwei Totzeitregister, ein Totzeit-Master-Register und ein Totzeit-Slave-Register auf, und der neue Wert für die Totzeit wird unabhängig von dem aktuellen, in dem Totzeit-Slave-Register abgelegten Wert der Totzeit zwischengespeichert.

Ebenso weist die Steuerung zur Doppelpufferüng der Periodendauer zusätzlich oder alternativ zwei Periodenregister, ein Perioden-Master-Register und ein Perioden-Slave-Register auf, und der neue Wert für die Periodendauer wird unabhängig von dem aktuellen, in dem Perioden-Slave-Register abgelegten Wert der Periodendauer zwischengespeichert.

Damit zuverlässig kein Einfluss auf die aktuelle Periode ausgeübt wird, ist die Steuerung dazu eingerichtet, den in einem Slave-Register abgelegten Wert mit dem in einem Master-Register zwischengespeicherten Wert zu Beginn der gewünschten Periode zu überschreiben.

Besonders einfach lässt sich die Steuerung ausführen, wenn sie dazu eingerichtet ist, den in einem Slave-Register abgelegten Wert mit dem in einem Master-Register zwischengespeicherten Wert zu Beginn jeder Periode zu überschreiben.

Im folgenden ist die Erfindung an Hand der Zeichnung näher erläutert. In dieser zeigen
- Fig. 1: einen Übertrager mit einer Steuereinheit,
- Fig. 2: ein Timingdiagramm für die beiden Ausgänge der Steuereinheit in Fig. 1,
- Fig. 3: ein weiteres Timingdiagramm,
- Fig. 4: ein Blockdiagramm der der Erfindung zu Grunde liegenden Hardware,
- Fig. 5: ein Zeitdiagramm einer erfindungsgemäßen Pulsweitenmodulation, und
- Fig. 6: ein Zeitdiagramm für eine 5-Phasen-Ansteuerung.

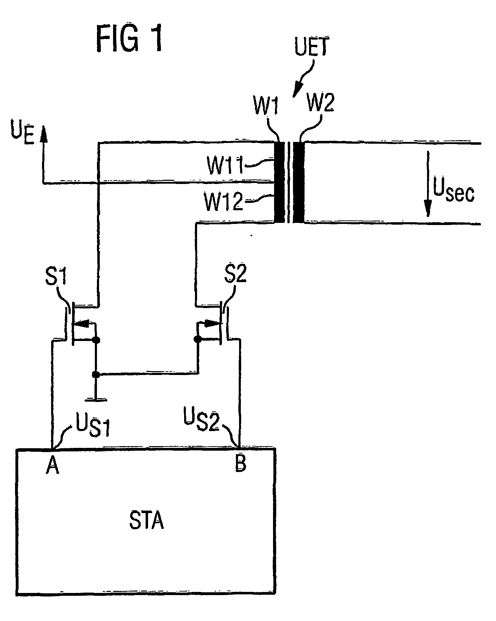

Fig. 1 zeigt einen Übertrager UET mit einer aus zwei Wicklungshälften W11, W12 bestehenden Primärwicklung W1 und einer Sekundärwicklung W2. Eine Eingangsgleichspannung U_{E}, z. B. 12 V, liegt mit ihrem Pluspol an der Mitte der Primärwicklung W1 und ist mit ihrem Minuspol über einen ersten getrennten Schalter S1 zu dem Anfang der ersten Wicklungshälfte W11 und über einen zweiten gesteuerten Schalter S2 zu dem Ende der zweiten Wicklungshälfte W12 geführt. Die beiden gesteuerten Schalter S1, S2, hier Feldeffekttransistoren, können von einer Ansteuerschaltung STA angesteuert werden. Die sich ergebende Sekundärspannung des Übertragers ist mit U_{sec} bezeichnet.

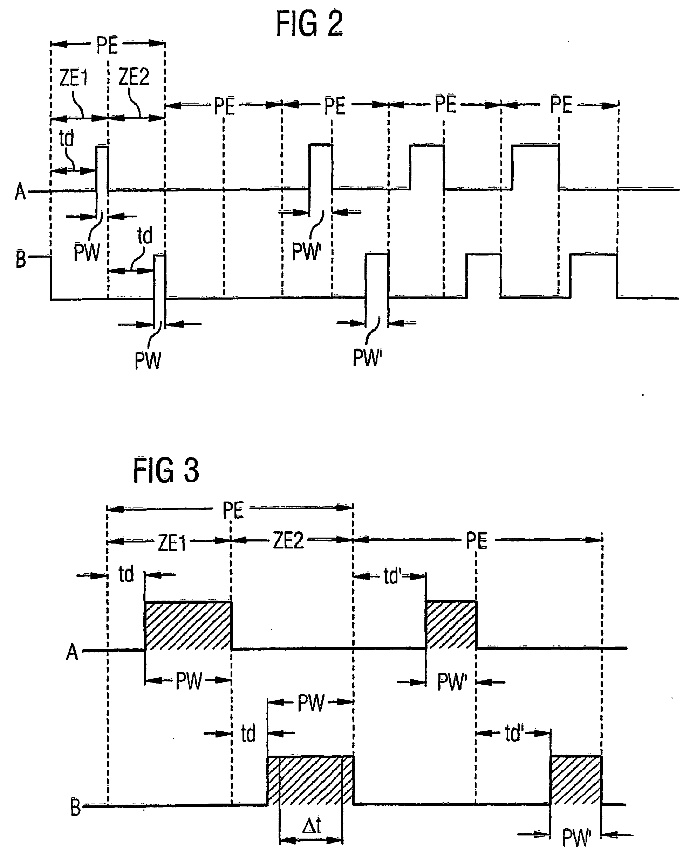

Wie Fig. 2 zu entnehmen, werden an die Primärwicklung W1 zwei gegenpolige, pulsweitenmodulierte Rechteckpulse gelegt, wobei jeder Puls entsprechend einer Halbwelle der zu erzeugenden Wechselspannung moduliert ist. Dabei sind die Impulse beider Pulse jeweils so gegeneinander verschoben, dass die Impulse eines Pulses in die Lücken des anderen Pulses fallen.

Diese Ansteuerimpulse, d.h. die Spannungen U_{S1} und U_{S2}, sind unter "A" und "B" in Fig. 2 für die beiden gesteuerten Schalter S1, S2, dargestellt. Die Gegenpoligkeit der Pulse wird hier durch abwechselndes Schalten der Eingangsspannung UE an eine der beiden Wicklungshälften W11, W12 erreicht. Bei einer einteiligen Primärwicklung W1 müssten vier gesteuerte Schalter verwendet werden, um diese Gegenpoligkeit zu erreichen.

Eine Überträgerlösung wie in Fig. 1 dargestellt benötigt sogenannte "symmetrische" Pulsfolgen "A" und "B", d.h. symmetrische Spannungsverläufe U_{S1}, U_{S2} an den Ausgängen der Ansteuerung STA, um zu verhindern, dass der Übertrager in die Sättigung gelangt, was zu einer Beschädigung oder Zerstörung des Übertragers führen würde.

Solche "symmetrische" Pulsfolgen sind in Fig. 2 dargestellt. Während einer Periode PE, die in einen ersten Zeitbereich ZE1 für den ersten Ausgang A und in einen weiteren Zeitbereich ZE2 für den zweiten Ausgang B unterteilt ist, weist dabei der Impuls A im ersten Zeitbereich ZE1 am ersten Ausgang der Ansteuerung STA dieselbe Breite auf wie der Impuls B im zweiten Zeitbereich ZE2 am zweiten Ausgang. Die Zeitbereiche ZE1, ZE2 stellen dabei gleichzeitig die maximale Pulsweite eines Signales an einem der Ausgänge A, B dar.

Bei einer solchen Pulsfolge kann die Pulsweite einfach durch Verändern der Breite des Pulses auf einen neuen Wert gesetzt werden. Bei zwei oder mehreren solchen Signalen wie in Fig. 2 dargestellt führt aber ein Erhöhen der Pulsweite des ersten Pulses A dazu, dass sich die Weite des zweiten Pulses B entsprechend verringert, in diesem Fall liegen dann keine symmetrischen Pulsfolgen mehr vor, der Übertrager geht in die Sättigung, was ja verhindert werden soll.

Prinzipiell ist es möglich, dass die Pulsweite des Signals A die gesamte Dauer des Zeitbereiches ZE1 und die Pulsweite des Signals b die Dauer des Zeitbereiches ZE2 ausmacht. Wie Fig. 2 und noch genauer Fig. 3 zu entnehmen ist, ist Weiters noch eine sogenannte "Totzeit" td vorgesehen, und ein Impuls beginnt in einer Periode PE erst nach Ablauf dieser Totzeit td. Der Impuls des Signals B beginnt erst nach Ablauf des Signals A, und hier auch erst wieder, nachdem die Totzeit td abgelaufen ist.

Die Erzeugung einer Totzeit bei Halb- oder Vollbrückenbetrieb hat normalerweise den Sinn, einen Brückenquerstrom, der die Leistungshalbleiter zerstören würde und der dann auftritt, wenn die zwei in einer Brücke befindlichen Halbleiter gleichzeitig (in Serie) leitend sind, zu verhindern.

Diese Totzeit wird meist bei der Initialisierung von Ansteuerungen, wie Microcontrollern, fix eingestellt und den Leistungshalbleitern und deren Treiberschaltungen angepasst. Die Pulsweite für jeden der Leistungshalbleiter, wie etwa Transistoren, kann einen Wert zwischen 0% und 100% jeweils von der Dauer des Zeitbereiches ZE1 bzw. ZE2 annehmen.

Die Erfindung macht sich nun diese Totzeit td zu Nutze, indem durch ein Verändern der Totzeit td auch die pulsweite PW der jeweiligen Signale A, B verändert wird. Wie Fig. 3 zu entnehmen ist, führt beispielsweise ein Erhöhen der Totzeit td auf einen neuen Wert td' (td' > td) dazu, dass sich die Pulsweite PW der Signale A, B entsprechend auf einen neuen Wert PW' verringert. Eine Verringerung der Totzeit td führt im selben Ausmaß zu einer Erhöhung der Pulsweite (siehe Fig. 2).

Diese Vorgangsweise hat den Vorteil, dass die Pulsweiten symmetrisch moduliert werden, d.h. eine Pulsweitenänderung eines ersten Signals führt im selben Ausmaß zu Änderungen der Pulsweite des zweiten oder weiteren Ausgängssignals.

Betrachtet man Fig. 3, so kann man erkennen, dass ohne Doppelpufferung der Totzeit grundsätzlich nur ein kleiner Zeitabschnitt Δt bleibt, in dem die Totzeit bzw. ein Totzeit-Register beispielsweise eines Microcontröllers, in dem der Wert für die Totzeit gespeichert ist, verändert werden darf.

Die Totzeit td darf nur in der zweiten Hälfte der Periode, d.h. während des Zeitbereiches ZE2 und nur dann auf den neuen Wert td' geändert werden, wenn die Totzeit td bereits abgelaufen ist. Außerdem muss verhindert werden, dass die Totzeit durch ein Laden mit einem neuen Wert zu einem Ausschalten der Ausgänge führt, z.B. würde man die Totzeit stark erhöhen, würde das dazu führen, dass Ausgang B ausschaltet.

Wenn die Pulsweite PW sehr klein ist (nahezu 0%), dann ist es außerdem unmöglich, die Totzeit für die nächste Periode zu laden. Die Folge ist ein fehlender Impuls, unsymmetrische pulsweitenmodulierte Signale oder Doppelpulse an einem Ausgang.

Im Gegensatz zu der Erzeugung eines herkömmlichen pulsweitenmodulierten Signals mittels eines Pulsweiten-Register im Microcontroller CON ist daher bei der Erfindung vorgesehen, dass erfindungsgemäß, um symmetrische, pulsweitenmodulierte Signale zu erzeugen, ein doppelt gepuffertes Totzeitregister mit entsprechender Auflösung (10 Bit und mehr) verwendet wird.

Dabei werden zu einem ohnehin auf dem Microcontroller CON vorhandenen Totzeit-Register zwei weitere Totzeit-Register, ein Master- und ein Slave-Register, wie weiter unten noch eingehender erläutert, hinzugefügt, oder es wird das bereits vorhandene Totzeit-Register auf dem Microcontroller CON durch ein weiteres, zusätzliches Register ergänzt.

Der erstere Fall bietet sich dabei an, wenn der microcontroller CON für die Erfindung durch ein weiteres Hardware-Modul ergänzt wird. Zweiterer Fall bietet sich bei der Neuentwicklung eines Microcontrollers an.

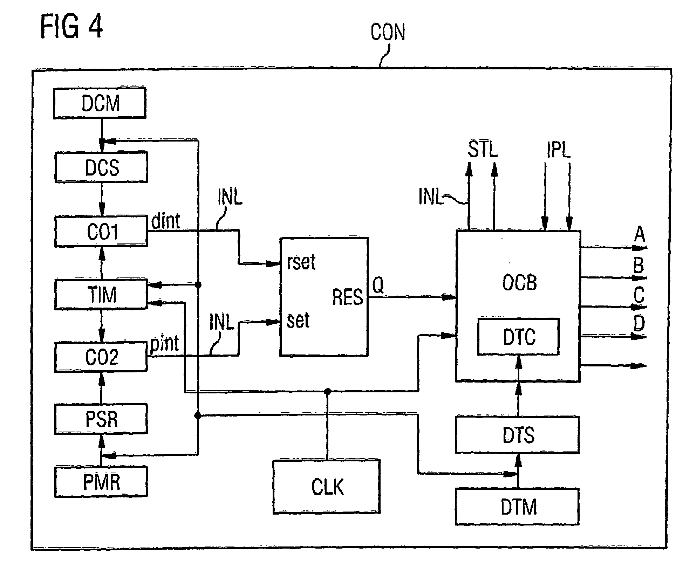

Wie der Fig. 4 zu entnehmen ist, weist die erfindungsgemäße Vorrichtung, hier in Form eines Microcontrollers CON, zwei oder mehr Ausgänge A, B, C, D, .... auf, die im zeitlichen Verlauf abwechselnd geschaltet sind. Der Haupttakt kommt dabei vom Ausgang Q, der Timer TIM ist der Takterzeuger.

Im folgenden wird zur eingehenden Erläuterung von zwei Ausgängen A, B ausgegangen. Damit jeweils zwei aufeinander folgende Impulse an den beiden Ausgängen A, B des Controllers CON exakt gleich sind, wird
a) vorerst die gewünschte Frequenz (Periode) eingestellt ,
b) die (maximale) Pulsweite, d.h. die Dauer eines Zeitbereiches ZE1, ZE2, die abwechselnd am Ausgang A und Ausgang B ausgegeben wird, auf exakt 50% der Pariodendäuer gestellt, und
c) das Totzeitregister an Stelle des Pulsweitenregisters entsprechend der sekundärseitig am Übertrager gewünschten Kurvenform moduliert. Eine Änderung der Totzeit td bewirkt dabei, dass beide Impulse auf den Ausgängen A und B um den gleichen Wert größer oder kleiner werden und somit die Signale symmetrisch moduliert werden.

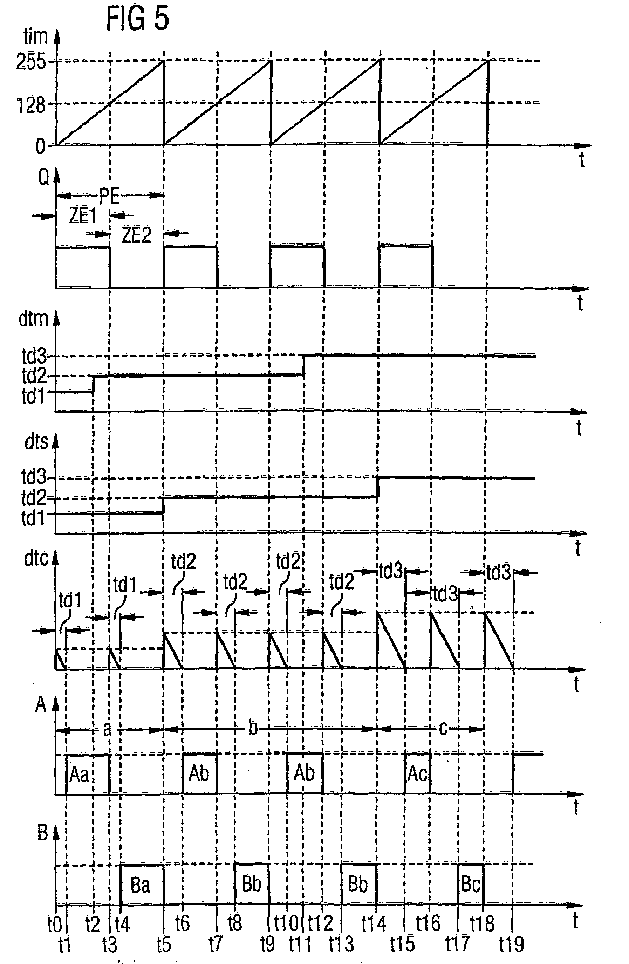

Dieses Update der Totzeit td kann vorteilsweise interruptgesteuert erfolgen, da in diesem Fall der normale Ablauf eines Programmes durch ein hochpriores Ereignis unterbrochen und dieses abgearbeitet wird (in diesem Fall der Update der Totzeit), und anschließend zum normalen Ablauf im Programm zu= rückgekehrt wird. Eine Doppelpufferung ist notwendig, damit ein Update der Totzeit erst in der nächstfolgenden Periode und nicht bereits im laufenden Impuls erfolgt, wie dies im folgenden an Hand der Figuren 4 und 5 näher erläutert wird.

In Fig. 4 sind die verwendeten Hardware-Komponenten und ihr Zusammenwirken im Rahmen der Erfindung an Hand eines Blockschaltbildes näher erläutert.

Mit der Clock Source CLK wird der Takt vorgegeben, der sich nach der gewünschten Auflösung und Frequenz der zu erzeugenden pulsweitenmodulierten Signale richtet. Zumeist wird der Takt von einem Hauptoszillator des verwendeten Microcontrollers abgeleitet. Diverse Vor- und Nachteiler, die programmierbar ausgeführt werden können, sorgen dafür, dass man sehr flexibel in der Programmierung des gewünschten Teilerverhaltnisses ist. Dies ist aus dem Grund von Vorteil, da der Hauptoszillator in der Regel im MHz-Bereich läuft, was zu hoch wäre, um ein symmetrisches pulsweitenmoduliertes Signal von beispielsweise 20 kHz zu erzeugen.

Natürlich ist es auch möglich, einen Taktgeber zu verwenden, der selbst die Schwingungen produzieren kann und der nicht mit dem Haupttakt zusammenhängt. Das hat den Vorteil, dass der Microcontroller seinen Haupttakt abschalten kann (Sleepmode, Stromsparmode) und die Pulsweitenmodulierung trotzdem weiterlaufen kann.

Der von der Clöck Source CLK gespeiste Timer TIM ist in dem gezeigten Beispiel ein automatisch rücksetzbares Zählregister mit entsprechender Auflösung (z.B. 16 Bit) und erzeugt mit seinem Zählerstand die Basis zum Vergleich mit den unten noch näher erläuterten Perioden- und Pulsweitenregistern, Beim Hochzählen ergibt sich ein Verlauf, wie er in Fig. 5 dargestellt ist, wobei der Timer-Verlauf mit tim bezeichnet ist. Die näherungsweise als Gerade gezeichnete Kurve ist in Wirklichkeit natürlich eine Treppenfunktion (für eine definierte Zeit wird ein Zählerstand gehalten, bevor er erhöht oder auf Null zurückgesetzt wird).

Weiters ist in Fig. 4 ein Duty Cycle Master Register DCM zu erkennen. Mit diesem Register DCM wird das Tastverhältnis eingestellt, d.h. das Verhältnis der Einschaltzeit zur Periodendauer bzw. das Einschaltverhältnis im Zeitbereich ZE1 bzw. im Zeitbereich ZE2 zur Gesamtdauer der Zeitbereiches ZE1, ZE2 (0% - 100% des Zeitabschnittes ZE1, ZE2). Von dem Duty Cycle Master DCM wird beim Erreichen des entsprechenden Zählerstandes für eine Periode der Wert in ein Register Duty Cycle Slave DCS übernommen.

Dieses Duty Cycle Slave-Register DCS ist direkt an der Erzeugung des Pulsweitenverhältnisses beteiligt.

Durch diese Doppelpufferung des Duty Cycle-Registers durch Verwendung eines Masters DCM und eines Slaves DCS wird eine Änderung des Tastverhältnisses zu einem grundsätzlich beliebigen Zeitpunkt möglich, da eine Änderung des Duty Cycles (Tastverhältnisses) zu einem beliebigen Zeitpunkt vorerst lediglich zu einer Änderung des entsprechenden Wertes im Master DCM führt und somit noch keine Auswirkungen auf den tatsächlichen Duty Cycle hat. Die Auswirkungen auf den Duty Cycle ergeben sich erst in der nächsten oder der gewünschten darauffolgenden Periode, für welche die Änderung wirksam werden soll, in dem dann der Master den Duty Cycle Slave DCS mit dem entsprechenden Wert updatet, was dann zu einer entsprechenden Änderung der Einstellungen des Duty Cycles führt. Auswirkungen der Änderung an dem Duty Cycle Register in einer bestimmten Periode kommen somit frühestens in der darauffolgenden Periode zur Wirkung.

Weiters ist Fig. 4 noch ein erster Comparator CO1 zu erkennen, der den Zählerstand des Timers TIM mit dem Wert des Registers Duty Cycle Slave DCS vergleicht. Sind die Zählerstände gleich, so wird ein Reset-Signal rset ausgegeben und an den Output Control Block OCB weitergegeben. Es wird ein Signal dint generiert, das als Interrupt weiterverarbeitet werden kann, und es beginnt die Totzeit td1 für den Ausgang B zu laufen.

Mit einem zweiten Komparator CO2 wird weiters der Zählerstand des Timers TIM mit dem Wert eines Period-Slave-Registers PSR verglichen, in dem die Periodendauer abgespeichert ist. Sind diese Zählerstände gleich, wird ein Set-Signal set aktiviert und dieses Signal set an den Output Control Block OCB weitergegeben. Es wird ein Signal generiert, dass als Interrupt pint weiterverarbeitet werden kann. Auf diese Weise wird das Ende der Periode angezeigt.

Außerdem wird der Zähler TIM auf den Wert "0" zurückgesetzt, die Werte aus den Master-Registern, wie z.B. dem Period Master Register; aber auch den im folgenden noch angeführten Master-Registern, in die Slave-Register übernommen und die Totzeit für den Ausgang "A" beginnt abzulaufen.

Der Period Master PMR dient zur Einstellung der Periodendauer der pulsweitenmodulierten Signale. Es sind damit beliebige Auflösungen der Pulsweite bis zur maximalen Auflösung des Timers TIM einstellbar. Bis zu diesem Wert wird der Timer TIM hochgezählt, bevor er auf "0" zurückgesetzt wird.

Vom Period Master Register PMR wird beim Erreichen des Zählerstandes für eine Periode der Wert in das Period Slave Register PSR übernommen. Dieses Slave-Register PSR ist direkt an der Erzeugung der Periodendauer wie oben beschrieben beteiligt.

Wiederum ermöglicht die Doppelpufferung durch Verwendung von Master PMR und Slave PSR im Allgemeinen eine Änderung der Periode zu einem beliebigen Zeitpunkt. Die Auswirkungen der Änderung erfolgt frühestens in der darauffolgenden Periode. Damit kann zwischen unterschiedlichen Frequenzen sehr leicht gewechselt werden, ohne die aktuelle Periodendauer damit zu beeinflussen.

Die für die Erfindung wesentlichsten Bestandteile sind im folgenden beschrieben. Im Gegensatz zu herkömmlichen Microcontrollern, wo lediglich ein Totzeitregister vorgesehen ist, erfolgt bei der Erfindung eine Doppelpufferung des Totzeitregisters. Dabei enthält das Register Dead Time Master DTM die Totzeit td, d.h. den Wert für die Zeit zwischen dem Ausschalten von Kanal A und dem Einschalten von Kanal B und umgekehrt.

Durch die Doppelpufferung, d.h. durch das zusätzlich vorhandenen Register Dead Time Slave DTS wird es nun möglich, dass der Wert der Totzeit td im Master-Register DTM zu einem beliebigen Zeitpunkten geändert werden kann, ohne dass dies unmittelbare unerwünschte Auswirkungen auf die Signale an den Ausgängen am Microcontroller hat. Erst frühestens nach einer vollständigen Periode wird der Wert in das Slave-Register DTS übertragen, und erst zu diesem Zeitpunkt werden dann die Signale am Ausgang A, B entsprechend symmetrisch geändert.

Wie beschrieben, ist das Dead Time Slave Register DTS direkt an der Totzeiterzeugung beteiligt. In Fig. 5 werden weiter unten auch noch die Auswirkung einer Totzeitänderung für zwei Ausgänge an einem Microcontroller CON näher erläutert.

Grundsätzlich können natürlich mit einem solcherart doppelgepufferten Totzeitregister nicht nur zwei sondern auch mehrere Ausgänge entsprechend gesteuert werden.

Werden mehrere Totzeitregister oder Totzeitregisterpaare (z.B. werden für einen 5-Phasenmotor fünf unabhängige Tot= zeit-Register benötigt) eingesetzt, so kann natürlich für jeden Ausgang bzw. für jedes Ausgangspaar bzw. für mehrere jeweils zusammenhängende Ausgangsgruppen jeweils eine eigene Totzeit eingestellt und auch unabhängig voneinander verändert werden.

Der Reset-Block RES dient schließlich noch zur Generierung der Pulsweite, d.h. der Ein- und Ausschaltzeit der einzelnen Ausgänge für den Output Control Block OCB, wobei diese Pulsweite aus der Periodendauer und dem Duty Cycle erzeugt wird, wie dies weiter oben erläutert wurde.

Der Output Control Block OCB schließlich beinhaltet unter anderem einen oder mehrere Dead Time Counter DTC, mit dessen bzw. deren Hilfe die Totzeitmodulation entsprechend den in den Totzeitregistern gesetzten Werten durchgeführt wird. Dabei ist pro zu erzeugender Totzeit ein solcher Dead Time Counter notwendig.

Zusätzlich kann in diesem Block OCB die Ansteuerung für einen, zwei oder mehrere Ausgänge erfolgen (mit und ohne Tot= zeitmodulation), und es können verschiedene Brückenkonfigurationen eingestellt werden (Halbbrücke, Vollbrücke, Drehströmbrücke, 5-phasen Brücke, ...).

Fig. 4 zeigt schließlich noch Status Lines STL sowie Input Lines zur Brückenkontrolle, mit INL sind Interrupt Lines bezeichnet.

Nach dieser allgemeinen Erläuterung der beteiligten Komponenten soll im folgenden die Erfindung noch an Hand der in Fig. 5 gezeigten Signalverläufe im Zusammenhang mit dem Blockschaltbild nach Fig. 4 für verschiedene Signale näher beschrieben werden.

Die Bezeichnungen am Diagramm sind im zusammenhang mit dem Blockschaltbild zu sehen.

Für das Beispiel wurde eine 8-bit Auflösung gewählt, d.h. es laufen die Zählerstände von 0 bis 255 (2⁸ = 256).

Um eine maximale Pulsweite der zu modulierenden Signale von 50% der Periodendauer zu erhalten, die für die Erfindung Vorteilhaft ist, liegt die Grenze des Zählerstandes für die Pulsweite bei 128.

Dieser Wert - die eigentliche Zeitangabe ergibt sich erst aus der Clöck-Source und Vorteilern für den Timer TIM - ist in dem Duty Cycle Slave Register DCS gespeichert. Der Comparator CO1 vergleicht den Zählerstand des Timers TIM mit dem im Register DCS gesetzten Wert, und sobald dieser erreicht wird, wird ein Reset-Signal rset generiert und über den Reset-Block RES an den Output Control Block OCB weitergeleitet. Das am Ausgang Q des Set-/Reset-Blocks RES generierte Signal zeigt den in Fig. 5 gezeigten Zeitverlauf, d.h. nachdem der Zählerstab des Timers TIM den im Register DCS gesetzten Wert erreicht hat, geht das Signal Q von "High" auf "Low".

Mit "Q" ist der Ausgang aus dem SET-/Reset-Block RES bezeichnet und zeigt ein Signal Tastverhältnis mit 50%, d.h. somit ist das Signal am Ausgang Q des Blocks RES für die erste Hälfte der Periode PE auf "High" und die zweite Hälfte der Periode auf "Low", was einer Dauer von 50% der Periode PE des Zeitbereiches ZE1 am Ausgang A und 50% der Periode PE des Zeitbereiches ZE2 am Ausgang B bedeutet.

Wie oben bereits erwähnt, ist mit Dead Time Counter DTC im Output Control Block OCB ein Zähler bezeichnet; der das Einschalten der entsprechenden Ausgänge um die Totzeit td verzögert, wobei dieser Counter mit dem in dem Dead Time Slave Register abgespeicherten Wert für die Totzeit geladen ist. Grundsätzlich können natürlich, je nach dem, wie viele Ausgänge unabhängig voneinander zu steuern sind, auch meherer solche Zähler vorgesehen sein.

Der Dead Time Counter DTC Wird zu Beginn jeder vollen Periode mit dem Wert des Dead Time Slaves geladen und zählt anschließend bis Null. Erst dann werden die entsprechenden Ausgänge freigegeben. Ist die Pulsweite, d.h. z.B. der Zeitbereich ZE1 am Ausgang Q, kleiner als die angegebene Totzeit, wird der entsprechende Ausgang nie gesetzt und bleibt immer ausgeschaltet.

Zu beachten ist, dass für die Erzeugung der maximal möglichen Einschaltzeit eines Ausganges die maximale Pulsweite, d.h. 100% des Zeitbereiches ZE1, sowie die minimale Totzeit, d.h. ein Wert von Null, einzustellen ist. Der Totzeitwert und die Pulsweite verhalten sich also gegenläufig, eine maximale Totzeit bedeutet eine Pulsweite von Null in den Zeitbereichen ZE1, ZE2.

Wie aus Fig. 5 zu erkennen ist, ist die Pulsweite über jede Periode gesehen exakt symmetrisch. A und B bezeichnen dabei die beiden Ausgänge des Microcontrollers, a, b, c die drei unterschiedlichen Modulations-Abschnitte (t0-t5: Abschnitt a, t5-t14: Abschnitt b, t14-t19: Abschnitt c, ...).

Das Update von Master- zu Slave-Registern und das Beschreiben des oder der Dead-Time Counter DTC erfolgt immer nur am Ende einer vollen Periode. Damit wird vermieden, dass die pulsweitenmodulierten Signale unsymmetrisch werden, oder Pulse verloren gehen, bzw. während einer laufenden Periode verändert werden.

Im folgenden werden die einzelnen Zeitabschnitte in Fig. 5 näher erläutert.

### t0-t1:

Der Dead Time Slave ist mit einem bestimmten Wert dts = td1 gesetzt, entsprechend beginnt zum Zeitpunkt t0 der Dead Time Counter DTC von diesem Wert dts bis auf Null herunterzuzählen, wie dies dem Signalverlauf dtc in Fig. 5 zu entnehmen ist. (Der Zeitpunkt t0 ist somit der frühestmögliche Einsetzzeitpunkt für den Kanal A, zum das Signal am Ausgang A auf "High" gehen würde, wenn eine Totzeit von Null eingestellt wäre.) Der Wert Null für das Signal dtc ist zum Zeitpunkt t1 erreicht, zu diesem Zeitpunkt ist die Totzeit (mit der Dauer td1 = t1-t0) abgelaufen, und das Ausgangssignal am Ausgang A wird auf "High" (Signal Aa) für den Rest des Zeitbereiches ZE1 gesetzt.

### t2:

Zu diesem Zeitpunkt wird, beispielsweise per Programm, das Master-Register DTM für die Totzeit geändert. Wie dem signalverlauf dtm zu entnehmen ist, wird dabei der aktuelle Wert des Signals dtm = td1, der dem Wert des Signals dts entspricht, um einen bestimmten Wert erhöht (oder erniedrigt, nicht dargestellt), d.h. die Totzeit auf den aktuellen Wert des Signals dtm = td2 gesetzt. Diese Änderung wirkt sich nur im Dead-Time Master DTM aus und hat daher keinen Einfluss auf die laufende Periode. Der Zeitpunkt der Änderung ist dabei relativ beliebig gewählt und ist lediglich so rechtzeitig vor Ablauf der laufenden Periode zu wählen, dass allfällige Rechenoperationen rechtzeitig vor Ablauf der Periode abgeschlossen sind.

### t3:

Zu diesem Zeitpunkt wird der Ausgang A ausgeschaltet, da dessen Einschaltzeit (= Dauer des Zeitbereiches ZE1 abzüglich der Totzeit td1) abgelaufen ist (t3 = "frühester" Einsetzzeitpunkt für das Signal am Ausgang B). Bei jedem Ende der eingestellten Pulsweite innerhalb einer Periode PE, d.h. hier des Endes der Einschaltzeit für den Ausgang A, wird das Totzeit-Zählregister dtc auf den Wert des im Dead-Time-Slave DTS gesetzten Wertes für dts, d.h. auf td1, gesetzt. Damit wird in diesem Fall die Totzeit td1 für den Ausgang B gestartet, die wiederum genau gleich groß wie jene für den Ausgang A ist.

### t4:

Zu diesem Zeitpunkt t4 ist die Totzeit td1 abgelaufen, der Ausgang B wird eingeschaltet, es ergibt sich ein Impuls Ba.

### t5:

Der Zeitpunkt t5 bezeichnet das Ende einer Periode PE, in diesem Fall der ersten dargestellten Periode, und der Ausgang B wird ausgeschaltet.

Außerdem wird der neue, aktuelle Wert des Dead-Time Master-Registers DTM wird in das korrespondierende Slave-Register DTS, wie dies auch an der Änderung des Signalverlaufs der Kurve dts zu erkennen ist, und gleichzeitig wird der neue Wert für die Totzeit td2 entsprechend dem neuen Wert für dts in den Totzeit-Zähler DTC im Output Control Block OCB geladen.

### t5-t11 :

Beginnend bei t5 zählt der Counter DTC von dem neuen, höheren Wert für dts auf Null herunter (t6), Ausgang A erzeugt ein entsprechendes Signal Ab. Zum Zeitpunkt t7 ist das Signal Ab am Ausgang A zu Ende, die Totzeit wird für den Ausgang B heruntergezählt, und das Signal B wird zum Zeitpunkt t8 auf "High" gesetzt (Signal Bb), entsprechend dem neuen Wert der Totzeit td2. Die beiden Verläufe Ab und Bb wiederholen sich in der nächsten Periode.

Zum Zeitpunkt t11 wird wiederum das Master-Register für die Totzeit geändert (neue Totzeit td3), in dem Beispiel auf einen nochmals höheren Wert dtm gesetzt. Die Änderung wirkt sich nur im Dead-Time Master DTM aus und hat daher keinen Einfluss auf die laufende Periode, entsprechend dem Verhalten im Zeitpunkt t2.

### t11-t14 :

Die Ausgänge A und B erzeugen nach wie vor pulsweitenmodulierte Signale entsprechend der eingestellten Totzeit td2 für den Zeitraum b.

### t14:

Der Zeitpunkt t14 bedeutet wieder das Ende einer Periode, und Ausgang B wird ausgeschaltet.

Der Wert des Dead-Time Master-Registers td3 wird in das korrespondierende Slave-Register und gleichzeitig in den Totzeit-Zähler im Output Controll Block geladen.

### t14-t19:

Entsprechend dieser neu geladenen Totzeit td3 erzeugen die Ausgänge A und B wieder entsprechende Signale, wie in Fig. 5 dargestellt, wo nach Ablauf der Totzeit td3 zu den Zeitpunkten t15 bzw. t17 das Signal am Ausgang A auf "High" (Signal Ac) bzw. das Signal am Ausgang B auf "High" (Signal Bc) gesetzt wird.

Um nun mit dem Übertrager einen entsprechenden Kurvenvetlauf erzeugen zu können, z.B. einen Sinus für Wechselrichter-Applikationen, muss die Auflösung groß gemacht werden.

Die gezeigten 8-bit sind nur als Beispiel zu sehen. Um beispielsweise eine Netzeinspeisung durchführen zu können, sollte eine Auflösung von 10-12 bit oder mehr verwendet werden.

Gemäß Fig. 5 fallen bei den zweikanaligen Signalen A, B die Impulse des einen Signale in die Lücken des anderen Signals. Dies ist aber nicht unbedingt notwendig.

Alternativ oder zusätzlich kann zur Pulsweitenmodulation auch die Periodendauer geändert werden, wodurch sich ebenfalls eine symmetrische Änderung der Pulsweiten ergibt. Zusätzlich zu der Änderung der Periodendauer muss dann aber auch eine Änderung des Tastverhältnisses über die Duty Cycle Register erfolgen, damit man ein Tastverhältnis von 50% erhält.

Auf diese Weise ist ein Modulationsverfahren wie beispielsweise FSK ("Frequency Shift Keying") möglich. Natürlich ist diese zu der Änderung der Totzeit alternative oder zusätzliche Variationsmöglichkeit nur dann einzusetzen, wenn eine Änderung der Periodendauer gewünscht ist oder zumindest keine nachteiligen Wirkungen aufweist.

Die prinzipielle Vorgangsweise bei der Änderung der Periodendauer ist wiederum dieselbe wie bei der Änderung der Totzeit, nämlich Doppelpufferung der Periodendauer durch Verwendung eines Perioden-Master- und eines Periodenslave-Registers PMR, PSR, wodurch es möglich wird, eine neue Periodendauer vorerst zu Generieren und auf dem Master PMR zwischenzuspeichern, ohne dadurch unerwünschte Änderungen der Periodendauer während der aktuellen Periode zu veranlassen. Zu Beginn der nächsten oder der gewünschten Periode wird dann der aktuelle Wert der Periodendauer im Slave-Register PMR mit dem neuen Wert des Master-Registers überschrieben und dieser Wert wird dann der aktuelle, gültige Wert für die Periodendauer bis zur nächsten Änderung.

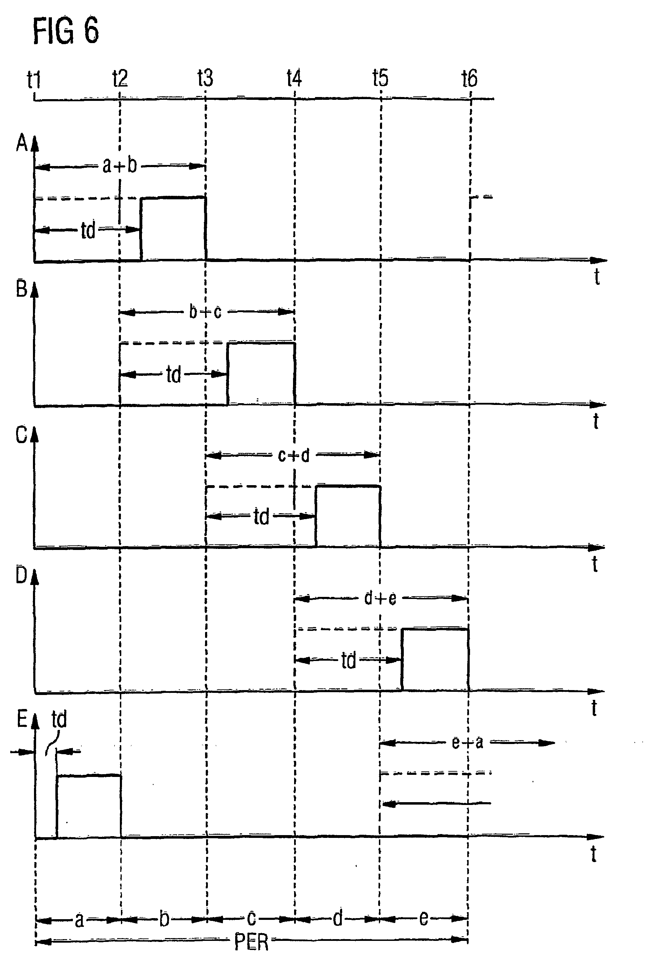

In Figur 6 ist schließlich noch der Signalverlauf bei einer 5-Phasen-Ansteuerung beispielsweise eines Motors dargestellt. Gemäß der Figur 6 setzt sich eine Periode bzw. ein Zyklus PER aus 5 Phasen bzw. Zeitbereichen a, b, c, d, e zusammen. Nach dem Beispiel erstreckt sich die maximale Einschaltdauer für einen Kanal über zwei Zeitbereiche, d.h. für den Kanal A über die Zeitbereiche a + b (Kanal B: b + c; Kanal C: c + d; Kanal D: d + e; Kanal E: e + a, wobei dieser letztere Zeitbereich a bereits in einer neuen Periode liegt).

Die aktuelle Totzeit td beginnt für jeden Kanal zu Beginn eines bestimmten Zeitabschnittes zu laufen, z.B. für Kanal A in der gezeigten Periode zum Zeitpunkt t1, für Kanal C z.B. zum Zeitpunkt t3, etc.

Wie man diesem Ausführungsbeispiel entnehmen kann, sind also auch überlappende Bereiche für die maximale Pulsweite möglich, und grundsätzlich wäre es dann auch möglich, die Totzeit so zu wählen, dass sich HIGH-Signale verschiedener Kanä= le zeitlich überlappen, und es kann somit auch der Signalverlauf nicht mehr "symmetrisch" sein.

Zum Zeitpunkt t1 werden die Slave-Register für die Totzeit mit dem aktuellen "Wert" td für die Totzeit geladen; der Master kann dann wenn gewünscht während der Periode t1 - t6 mit einem neuen Wert für die Totzeit geladen werden, welche dann zum Zeitpunkt t6, d.h. dem Beginn des neuen Zyklus, in die Slave-Register geschrieben wird. Aufgrund der überlappenden Bereiche ist es dabei notwendig, dass jeder Kanal A - E über ein eigenes Slave-Register für die Totzeit versorgt wird, der Master somit 5 Slave-Register updatet, die dann der Reihe nach "ablaufen". Würden sich die Signale, d.h. die maximal mögliche Pulsdauern (a + b; b + c; etc.) der Signales, nicht überlappen, wäre im Rahmen der Doppelpufferung auch nur ein Slave-Register notwendig.

Bei den vorgestellten erfindungsgemäßen Verfahren zur Pulsweitenmodulierung ist ein wesentlicher Aspekt, dass die Mitte des modulierten Pulses des Signals jeweils mit verschoben wird. Andere Verfahren sind bekannt; wo um die Mitte herum moduliert wird, d.h. die Position der Mitte bei einer Modulation unverändert bleibt. Versuche und Berechnungen haben allerdings gezeigt, dass solche hinsichtlich der elektromagnetischen Verträglichkeit in wichtigen Frequenzbereichen wesentliche Nachteile gegenüber den vorliegenden Verfahren aufweisen und somit die Verwendung von Filtern notwendig machen, was bei der vorliegenden Erfindung entfällt.

Der zusätzliche Aufwand, der bei der Erfindung gegenüber einem herkömmlichen Microcontroller durch die Doppelpufferung der entsprechenden Register im PWM-Teil entsteht, ist sehr gering im Gegensatz zum Nutzen der vorliegenden Erfindung.

Die Chipfläche vergrößert sich nur um einige Register, das ergibt keinen merklichen Kostenanstieg im Endprodukt, da die Fläche nur um einige µm² steigt.

Natürlich kann mit dem neuen Konzept eine "normale" PWM erzeugt werden, ohne die bestehenden Programme oder Schaltungen ändern zu müssen.

Wird eine derartige Hardware am Chip realisiert, können 90% der Programmressourcen gespart werden. Diese verfügbare Programmzeit im Micröprozessor ist dann frei für zusätzliche Steuerungs- und Regelungsaufgaben. Es kann für ein Produkt auf einen günstigeren Controller umgestiegen werden bei gleichbleibender Performance.

Die Erfindung eignet sich beispielsweise zum Einsatz in getakteten Stromversorgungen, für Wechselrichter, Solarwechselrichter, netzgeführte Wechselrichter-Anwendung, z.B. Rückspeisung ins öffentliche Stromnetz, bei denen eine Gleichspannung oder gleichgerichtete Wechselspannung in eine andere Wechselspannung, vorzugsweise niedriger Frequenz umgerichtet werden soll. Außerdem eignet sich die Erfindung weiteres auch noch etwa für getaktete Strom- und Spannungsversorgungen und zur Motoransteuerung.

## Patentansprüche

1. Verfahren zur Erzeugung von zwei- oder mehrkanaligen pulsweitenmodulierten Rechteckpulsen (Aa, Ab, Ac; Ba, Bb, Bc), bei dem innerhalb einer Periode (PE) an jedem Kanal genau ein Puls abgegeben wird, und das Einsetzen eines Pulses bezogen auf einen Einsetzzeitpunkt (t0, t3, t5, t7, ...; t1, t2, t3, t4, t5, t6) um eine aktuelle Totzeit (td) zeitverzögert wird, die Totzeit (td) jeweils für zumindest eine Periode konstant gehalten wird,
**dadurch gekennzeichnet, dass** für eine Modulation der Pulsweite (PW, PW') ein neuer Wert für die Totzeit (td') erzeugt wird und die aktuelle Totzeit (td) zu Beginn der gewünschten Periode auf den neuen Wert der Totzeit (td') gesetzt wird.

2. Verfahren nach Anspruch 1,
**dadurch gekennzeichnet, dass** zwei aufeinanderfolgende Pulse an verschiedenen Kanälen jeweils zeitlich durch eine aktuelle Totzeit (td) voneinander getrennt sind.

3. Verfahren nach Anspruch 1 oder 2,
**dadurch gekennzeichnet, dass** der neue Wert der Tot= zeit (td') unabhängig von dem aktuellen Wert der Totzeit (td) zwischengespeichert und der aktuelle Wert mit dem neuen Wert zu Beginn der gewünschten Periode überschrieben wird.

4. Verfahren nach einem der Ansprüche 1 bis 3,
**dadurch gekennzeichnet, dass** die Totzeit zu Beginn jeder Periode auf den neuen Wert (td') gesetzt wird.

5. Verfahren nach einem der Ansprüche 1 bis 4,
**dadurch gekennzeichnet, dass** die maximale Pulsweite für einen Kanal auf die Dauer der Periode geteilt durch die Anzahl der Kanäle gesetzt wird.

6. Verfahren nach Anspruch 5,
**dadurch gekennzeichnet, dass** bei zwei Kanälen die maximale Pulsweite auf die halbe Dauer einer Periode gesetzt wird.

7. Verfahren nach einem der Ansprüche 1 bis 6,
**dadurch gekennzeichnet, dass** bei n Kanälen jeweils nach Ablauf der Dauer der maximalen Pulsweite für den ersten bis den (n-1)-ten Kanal ein Interrupt-Signal (rset) erzeugt und der Beginn der Totzeit für den nächsten Kanal angezeigt wird.

8. Verfahren nach Anspruch 7,
**dadurch gekennzeichnet, dass** am Ende einer Periode ein Interrupt-Signal (set) generiert wird, mit dem der Beginn der Totzeit für den ersten Kanal bzw. der Beginn einer neuen Periode markiert wird.

9. Verfahren nach Anspruch 8,
**dadurch gekennzeichnet, dass** mit dem Interrupt-Signal (set) das Überschreiben der aktuellen Totzeit mit dem neuen Wert für die Totzeit initiiert wird.

10. Vorrichtung zum Durchführen eines Verfahrens nach einem der Ansprüche 1 bis 9,
**dadurch gekennzeichnet, dass** sie zwei Totzeitregister, ein Totzeit-Master-Register (DTM) und ein Totzeit-Slave-Register (DTS) aufweist, und dass der neue Wert für die Totzeit (td') unabhängig von dem aktuellen, in dem Totzeit-Slave-Register (DTS) abgelegten Wert (td) der Totzeit zwischengespeichert wird.

11. Vorrichtung nach Anspruch 10,
**dadurch gekennzeichnet, dass** sie dazu eingerichtet ist, den in einem Slave-Register (DTS) abgelegten Wert mit dem in einem Master-Register (DTM) zwischengespeicherten Wert zu Beginn der gewünschten Periode zu überschreiben.

12. Vorrichtung nach Anspruch 11,
**dadurch gekennzeichnet, dass** sie dazu eingerichtet ist, den in einem Slave-Register (DTS) abgelegten Wert mit dem in einem Master-Register (DTM) zwischengespeicherten Wert zu Beginn jeder Periode zu überschreiben.

## Claims

1. Method for producing two-channel or multi-channel pulse-width modulated rectangular pulses (Aa, Ab, Ac; Ba, Bb, Bc), in which, within a period (PE) exactly one pulse is discharged in each channel, and the inception of a pulse in relation to the moment of inception (t0, t3, t5, t7, ... ; t1, t2, t3, t4, t5, t6) is delayed by an actual dead time (td), the dead time (td) being kept constant for at least one period in each case,
**characterised in that** for a modulation of the pulse width (PW, PW') a new value for the dead time (td') is produced and the current dead time (td) is set at the beginning of the desired period to the new value of the dead time (td').

2. Method according to claim 1,
**characterised in that** two consecutive pulses in different channels are each separated from each other in time by a current dead time (td).

3. Method according to claim 1 or 2,
**characterised in that** the new value of the dead time (td') is buffered independently of the current value of the dead time (td) and the current value is overwritten with the new value at the beginning of the desired period.

4. Method according to one of the claims 1 to 3,
**characterised in that** the dead time is set to the new value (td') at the beginning of each period.

5. Method according to one of the claims 1 to 4,
**characterised in that** the maximum pulse width for a channel is set to the duration of the period divided by the number of the channels.

6. Method according to claim 5,
**characterised in that**, with two channels, the maximum pulse width is set to half the duration of a period.

7. Method according to one of the claims 1 to 6,
**characterised in that**, with n channels, after the duration of the maximum pulse width has elapsed for the first to the (n-1) channel, an interrupt signal (rset) is created and the beginning of the dead time for the next channel is shown.

8. Method according to claim 7,
**characterised in that**, at the end of a period an interrupt signal (set) is generated, with which the beginning of the dead time for the first channel or the beginning of a new period is marked.

9. Method according to claim 8,
**characterised in that** the overwriting of the current dead time with the new value for the dead time is initiated with the interrupt signal (set).

10. Device for implementing a method according to one of claims 1 to 9, **characterised in that** it features two dead time registers, one dead time master register (DTM) and one dead time slave register (DTS) and that the new value for the dead time (td') is buffered independently of the current value (td) of the dead time stored in the dead time slave register (DTS).

11. Device according to claim 10,
**characterised in that** it is set up to overwrite the value stored in a slave register (DTS, PSR) with the value buffered in a master register (DTM, PMR) at the beginning of the desired period.

12. Device according to claim 11,
**characterised in that** it is set up to overwrite the value stored in a slave register (DTS, PSR) with the value buffered in a master register (DTM, PMR) at the beginning of each period.

## Revendications

1. Procédé de production d'impulsions rectangulaires (Aa, Ab, Ac ; Ba, Bb, Bc) modulées en largeur d'impulsion et à deux ou plusieurs canaux, dans lequel on fournit exactement une impulsion à chaque canal à l'intérieur d'une période (PE) et on retarde d'un temps mort actuel (td) l'envoi d'une impulsion par rapport à un instant d'envoi (t0, t3, t5, t7, ... ; t1, t2, t3, t4, t5, t6), le temps mort (td) étant à chaque fois maintenu constant pour au moins une période,
**caractérisé par le fait que**, pour une modulation de la largeur d'impulsions (PW, PW'), on produit une nouvelle valeur pour le temps mort (td') et on pose le temps mort en cours (td) au début de la période souhaitée égal à la nouvelle valeur du temps mort (td').

2. Procédé selon la revendication 1,
**caractérisé par le fait que** deux impulsions successives sur différents canaux sont séparées temporellement l'une de l'autre à chaque fois par un temps mort en cours (td).

3. Procédé selon la revendication 1 ou 2,
**caractérisé par le fait qu'**on mémorise temporairement la nouvelle valeur du temps mort (td') indépendamment de la valeur en cours du temps mort (td) et qu'on remplace la valeur en cours par l'écriture de la nouvelle valeur au début de la période souhaitée.

4. Procédé selon l'une des revendications 1 à 3,
**caractérisé par le fait qu'**on pose le temps mort au début de chaque période égal à la nouvelle valeur (td').

5. Procédé selon l'une des revendications 1 à 4,
**caractérisé par le fait qu'**on pose la largeur maximale d'impulsion pour un canal égale à la durée de la période divisée par le nombre des canaux.

6. Procédé selon la revendication 5,
**caractérisé par le fait que**, en présence de deux canaux, on pose la largeur maximale d'impulsion égale à la moitié de la durée d'une période.

7. Procédé selon l'une des revendications 1 à 6,
**caractérisé par le fait que**, en présence de n canaux, après chaque écoulement de la durée de la largeur maximale d'impulsion pour le premier au (n - 1)ème canal, on produit un signal d'interruption (rset) et on indique le début du temps mort pour le prochain canal.

8. Procédé selon la revendication 7,
**caractérisé par le fait que**, à la fin d'une période, on produit un signal d'interruption (set) avec lequel on marque le début du temps mort pour le premier canal respectivement le début d'une nouvelle période.

9. Procédé selon la revendication 8,
**caractérisé par le fait que**, avec le signal d'interruption (set), on déclenche le remplacement du temps mort en cours par l'écriture de la nouvelle valeur pour le temps mort.

10. Dispositif pour la mise en oeuvre d'un procédé selon l'une des revendications 1 à 9,
**caractérisé par le fait qu'**il comporte deux registres de temps mort, un registre maître de temps mort (DTM) et un registre esclave de temps mort (DTS), et que la nouvelle valeur pour le temps mort (td') est mémorisée temporairement indépendamment de la valeur en cours (td), enregistrée dans le registre esclave de temps mort (DTS), du temps mort.

11. Dispositif selon la revendication 10,
**caractérisé par le fait qu'**il est conçu pour, au début de la période souhaitée, remplacer la valeur enregistrée dans un registre esclave (DTS) par l'écriture de la valeur mémorisée temporairement dans un registre maître (DTM).

12. Dispositif selon la revendication 11,
**caractérisé par le fait qu'**il est conçu pour, au début de chaque période, remplacer la valeur enregistrée dans un registre esclave (DTS) par l'écriture de la valeur mémorisée temporairement dans un registre maître (DTM).
